# EUROPÄISCHE PATENTSCHRIFT

(11) **EP 0 651 598 B1**
(45) Veröffentlichungstag und Bekanntmachung des Hinweises auf die Patenterteilung: **30.06.1999**
(21) Anmeldenummer: 94203095.8
(22) Anmeldetag: 25.10.1994
(51) Int. Cl.: H05K 1/14, H05K 1/02, H05K 9/00

(54) **Elektronisches Schaltungsmodul**
Electronic circuit module
Module de circuit électronique

(30) Priorität: 02.11.1993 DE 4337258
(43) Veröffentlichungstag der Anmeldung: 03.05.1995
(73) Patentinhaber: LUCENT TECHNOLOGIES INC., Murray Hill, New Jersey 07974-0636 (US)
(72) Erfinder: Frisch, Wilhelm, D-20097 Hamburg (DE); Kaiser, Werner, Dipl.-Ing. (TU), D-20097 Hamburg (DE); Ott, Gerhard, Dipl.-Ing. (FH), D-20097 Hamburg (DE); Kettschau, Hans-Jürgen, Dipl.-Ing., D-20097 Hamburg (DE); Ludwig, Uwe, Dipl.-Ing. (FH), D-20097 Hamburg (DE); Ziegler, Bernhard, Dipl.-Ing. (FH), D-20097 Hamburg (DE)
(74) Vertreter: Johnston, Kenneth Graham

(56) Entgegenhaltungen:
- EP-A- 0 065 425
- EP-A- 0 303 975
- DE-A- 3 404 644
- DE-A- 3 922 461
- PATENT ABSTRACTS OF JAPAN vol. 17, no. 15 (E-1305) 12. Januar 1993 & JP-A-04 245 700 (MATSUSHITA ELECTRIC IND CO) 2. September 1992
- PATENT ABSTRACTS OF JAPAN vol. 13, no. 312 (E-788) 17. Juli 1989 & JP-A-01 084 787 (MITSUBISHI ELECTRIC CORP.) 30. März 1989

## Beschreibung

Die Erfindung bezieht sich auf ein elektronisches Schaltungsmodul mit einer Leiterplatte gemäß dem Oberbegriff des Anspruchs 1.

Aus der US-Patentschrift 4,858,073 ist eine Leiterplatte der eingangs genannten Art bekannt. In Fig. 8 ist eine nicht planare Ausgestaltung dargestellt, bei der die Leiterplatte an zwei gegenüberliegenden Seiten umgebogen ist. Einer der beiden umgebogenen Teile der Leiterplatte ist ein weiteres Mal umgebogen. Die elektrisch isolierende Schicht ist aus biegsamen Material hergestellt, so daß sich eine insgesamt biegsame Leiterplatte ergibt. Eine gut wärmeleitende Schicht dient zum Ableiten von Verlustwärme, die von den auf der Leiterplatte montierbaren Bauelementen erzeugt wird.

Aus der DE-A-3 404 644 A1 ist ein Verfahren zum Herstellen von doppelstöckigen Leiterplatten sowie eine doppelstöckige Leiterplatte bekannt, die aus einer Kunststoffschicht mit einseitiger Kupferkaschur besteht. In die nicht mit Kupfer kaschierte Fläche der Kunststoffschicht sind zwei Rillen eingebracht, entlang derer die Leiterplatte rechtwinkelig abgebogen wird.

Der Erfindung liegt die Aufgabe zugrunde, ein elektronisches Schaltungsmodul der eingangs genannten Art anzugeben, bei der die Leiterplattenoberfläche besser ausgenutzt werden kann.

Die Aufgabe wird durch die Merkmale des Anspruchs 1 und insbesondere dadurch gelöst , daß sowohl die erste als auch die zweite Seite der elektrisch isolierenden Schicht jeweils eine Metallschicht zur Bildung von Leiterbahnen und zum Tragen von oberflächenmontierbaren Bauelementen aufweist.

Das Schaltungsmodul weist somit wenigstens einen durch Umbiegen eines Abschnitts der Leiterplatte entstandenen Schenkel auf, auf dem wie im übrigen Bereich oberflächenmontierbare Bauelemente angeordnet sind. Der Platzbedarf bzw. die notwendige Grundfläche des Schaltungsmoduls wird auf diese Weise verringert. Durch die im Bereich der Biegekanten vorgesehene Vertiefung und die Unterbrechung der gut wärmeleitenden Schicht wird das Biegen der Leiterplatte ermöglicht bzw. erleichtert, wenn die elektrisch isolierende Schicht aus einem Material besteht, daß nicht bzw. nur schlecht biegsam ist.

In einer Ausgestaltung der Erfindung ist die Vertiefung als Kerbe ausgebildet, die im nicht gebogenen Zustand der Leiterplatte (1) einen Querschnitt aufweist, der in etwa einen rechten Winkel darstellt.

Eine solche Kerbe ist besonders einfach beispielsweise durch einen Fräsvorgang herstellbar.

In einer anderen Ausgestaltung der Erfindung ist die Leiterplatte u-förmig gebogen.

Diese platzsparende Form der Leiterplatte wird durch Umbiegen von zwei Abschnitten der Leiterplatte erzeugt. Dabei stehen die umgebogenen Abschnitte in etwa rechtwinklig auf der übrigen Fläche der Leiterplatte.

Weiterhin wird die Erfindung dadurch ausgestattet, daß in den Randbereich eines Abschnitts der Leiterplatte elektrische Anschlußstifte gefräst sind.

Mit Hilfe der elektrischen Anschlußstifte, die durch Fräsen einfach und preisgünstig herstellbar sind, kann die Leiterplatte bzw. das elektrische Schaltungsmodul auf einer anderen Leiterplatte angelötet werden. Eine elektrische Kontaktierung durch Löten ist sicherer und für viele Anwendungsfälle auch preisgünstiger als eine Kontaktierung mit speziellen Steckkontakten.

Bei oberflächenmontierbaren Bauelementen, die eine große Verlustwärme erzeugen, kann bei der so ausgestatteten Anordnung einem Ausfall durch Überhitzung der Bauelemente entgegengewirkt werden.

Weiterhin kann die Erfindung dadurch ausgestattet werden, daß ein quaderförmiger auf seiner Unterseite offener Metallaufsatz für die Leiterplatte vorgesehen ist.

Ein solcher Metallaufsatz dient zur Abschirmung von elektromagnetischer Strahlung und zur Erhöhung der mechanischen Stabilität des elektronischen Schaltungsmoduls. Er verbessert außerdem die Wärmeableitung von der Leiterplatte.

Der Metallaufsatz weist in einer Ausgestaltung der Erfindung an den Unterkanten der Seitenwände Lötstifte auf.

Mit Hilfe der Lötstifte wird der Metallaufsatz auf derselben Oberfläche wie die Leiterplatte festgelötet. Das elektronische Schaltungsmodul ist damit auf einfache Weise auf einer solchen Oberfläche fixiert, die beispielsweise eine andere Leiterplatte sein kann.

In einer anderen Ausgestaltung der Erfindung ist auf der Oberseite des Metallaufsatzes ein Kühlkörper angeordnet.

Für sehr hohe Verlustleistungen der oberflächenmontierbaren Bauelemente sind die Wärmeableiteigenschaften der oben beschriebenen Anordnung nicht ausreichend. Ein auf der Oberseite des Metallaufsatzes angeordneter Kühlkörper bewirkt vorteilhaft einen erheblich reduzierten Wärmeübergangswiderstand zur Umgebung und damit ein verbessertes Wärmeableitverhalten des elektronischen Schaltungsmoduls.

Ein Ausführungsbeispiel der Erfindung wird nachstehend an Hand der Zeichnungen näher erläutert.

Es zeigen:
- Fig. 1: ein elektronisches Schaltungsmodul bestehend aus einer Leiterplatte und einem Metallaufsatz,
- Fig. 2: einen Teil der nicht gebogenen Leiterplatte im Querschnitt und
- Fig. 3: einen Teil der gebogenen Leiterplatte im Querschnitt.
- Fig. 4: eine erfindungsgemäße, beidseitig mit Bauelementen bestückte, gebogene Leiterplatte im Querschnitt.

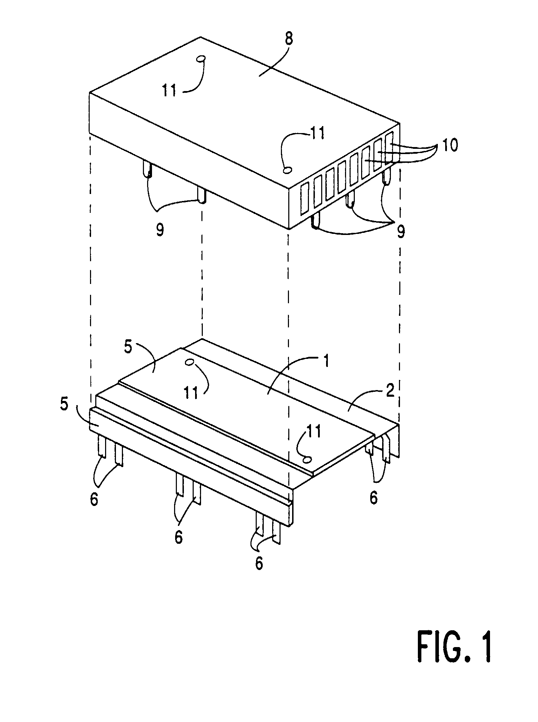

Das in den Fig. 1 bis 3 als Beispiel beschriebene elektronische Schaltungsmodul mit einer Leiterplatte 1 weist eine elektrisch isolierende Schicht 2 auf, die insbesondere aus schlecht oder nicht biegsamen Materialien wie Epoxid-Harz oder Keramik besteht. Auf der Unterseite der elektrisch isolierenden Schicht 2 ist eine erste Metallschicht 3 angebracht, die zur Bildung von Leiterbahnen vorgesehen ist. Auf der Metallschicht 3 sind oberflächenmontierbare Bauelemente 4 angeordnet, die mit den Leiterbahnen der Metallschicht 3 verlötet sind. Zur Ableitung von im Betrieb der oberflächenmontierbaren Bauelemente erzeugten Verlustwärme ist eine gut wärmeleitende Schicht 5 auf der Oberseite der elektrisch isolierenden Schicht 2 vorgesehen.

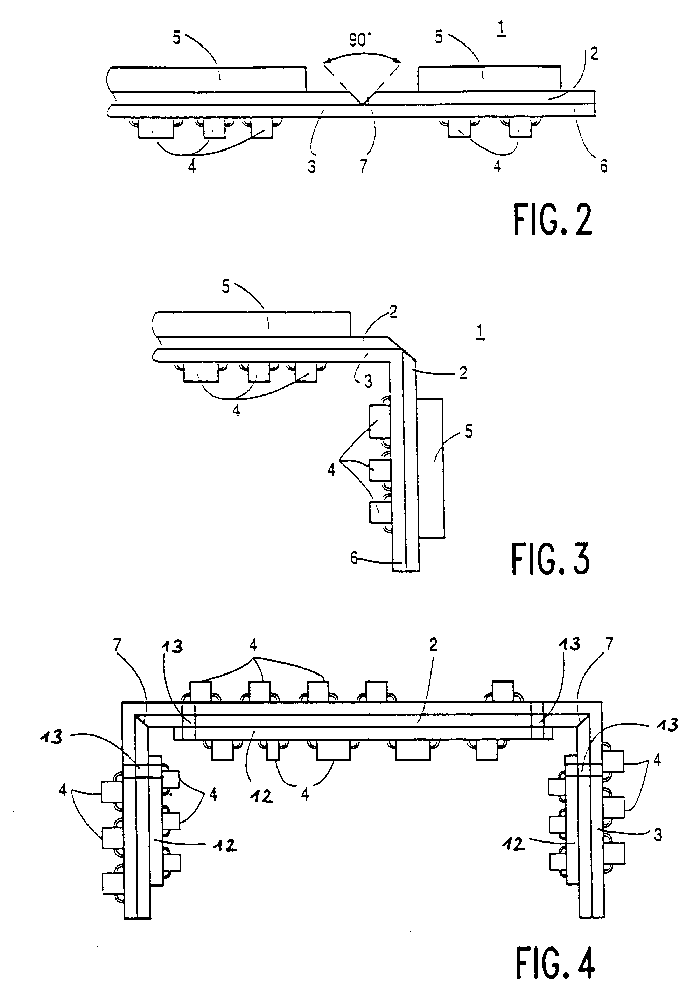

Zur Verwendung der Leiterplatte 1 als Teil des elektronischen Schaltungsmoduls wird diese u-förmig gebogen. Die dabei entstehenden zwei Schenkel weisen in Richtung der Metallschicht 3 bzw. der oberflächenmontierbaren Bauelemente 4. Auf diese Weise entsteht ein Innenbereich des Schaltungsmoduls auf der Seite der oberflächenmontierbaren Bauelemente 4 und ein Außenbereich des Schaltungsmoduls auf der Seite der gut wärmeleitenden Schicht 5. In ihrem Randbereich weisen die beiden Schenkel elektrische Anschlußstifte 6 auf, die durch Fräsen der Leiterplatte 1 hergestellt sind. Im Bereich der elektrischen Anschlußstifte 6 ist die gut wärmeleitende Schicht 5 entfernt. Im Bereich der Biegekanten ist die gut wärmeleitende Schicht 5 unterbrochen, um den Verbund unterschiedlicher Materialien beim Biegen nicht zu zerstören. Weiterhin ist in diesem Bereich in die elektrisch isolierende Schicht 2 wie aus Fig. 2 ersichtlich im nichtgebogenen Zustand der Leiterplatte 1 eine Vertiefung 7 angebracht. Die Vertiefung 7 ist im vorliegenden Fall eine Kerbe, die leicht durch einen Fräsvorgang erzeugt werden. Sie stellt dann wie im vorliegenden Ausführungsbeispiel in ihrem Querschnitt in etwa einen rechten Winkel dar. Die Vertiefung 7 durchstößt im vorliegenden Fall die gesamte elektrisch isolierende Schicht 2 und definiert eine Biegekante der Leiterplatte 1. Ein Biegen der Leiterplatte 1 ist damit auch bei einer nicht bzw. schlecht zu biegenden elektrisch isolierenden Schicht 2 leicht möglich. Auch wenn die Vertiefung 7 die elektrisch isolierende Schicht 2 nicht völlig, sondern nur bis auf eine Restschicht geringer Dicke durchstößt, ist das Biegen der Leiterplatte 1 ermöglicht bzw. erleichtert. Die Vertiefung 7 kann auch auf andere Weise, z.B. als Nut ausgeführt werden. Der Teil der Leiterplatte 1 mit der in gleicher Weise ausgeführten zweiten Biegekante 1 ist in Fig. 2 und 3 nicht dargestellt.

Mit Hilfe der elektrischen Anschlußstifte 6 wird die Leiterplatte 1 beispielsweise auf einer anderen Leiterplatte befestigt bzw. angelötet und elektrisch kontaktiert. Die oberflächenmontierbaren Bauelemente 4 sind auch auf den Schenkeln der Leiterplatte 1 angeordnet. Der Platzbedarf der Leiterplatte 1, insbesondere die erforderliche Grundfläche auf der anderen Leiterplatte, wird auf diese Weise reduziert. Über die Leiterplatte 1 wird ein Metallaufsatz 8 gestülpt, der quaderförmig und auf seiner Unterseite offen ist. Auf der Unterseite der Seitenwände des Metallaufsatzes 8 sind Lötstifte 9 vorgesehen, mit denen der Metallaufsatz 8 wie die Leiterplatte 1 auf der anderen Leiterplatte angelötet und befestigt wird. Der Metallaufsatz 8 weist auf zwei gegenüberliegenden Seitenwänden Lüftungsöffnungen 10 auf, die einem Wärmestau im Innenbereich des elektronischen Schaltungsmoduls verhindern. Der Metallaufsatz 8 dient zur Abschirmung elektromagnetischer Strahlung, zur Erhöhung der mechanischen Stabilität des elektronischen Schaltungsmoduls und zur verbesserten Ableitung von Verlustwärme der oberflächenmontierbaren Bauelemente 4. Er reduziert den Wärmeübergangswiderstand des elektronischen Schaltungsmoduls zur Umgebung. Die Verlustwärme wird über die Leiterbahnen der Metallschicht 6, die elektrisch isolierende Schicht 2, und die gut wärmeleitende Schicht 5 dem Metallaufsatz 8 zugeführt und an die Umgebung abgeleitet. Die elektrisch isolierende Schicht 2 ist zu diesem Zweck von geringer Dicke, so daß der Wärmeübergang an die Umgebung nicht übermäßig gestört wird.

Die Leiterplatte 1 und der Metallaufsatz 8 weisen Bohrungen 11 auf, die zur Befestigung eines nicht dargestellten Kühlkörpers mit Hilfe von beispielsweise Schraubverbindungen dienen. Ein solcher Kühlkörper verbessert die Wärmeableitung falls erforderlich zusätzlich.

Die in Fig. 4 dargestellte Leiterplatte eines erfindungsgemäßen elektronischen Schaltungsmoduls weist im Gegensatz zu der in den Fig. 1 bis 3 dargestellten Beispielsform anstelle einer gut wärmeleitenden Schicht zur Wärmeableitung eine zweite Metallschicht 12 zur Bildung von Leiterbahnen und zum Tragen von oberflächenmontierbaren Bauelementen auf. Der Platzbedarf des elektronischen Schaltungsmoduls läßt sich durch eine solche Maßnahme weiter reduzieren. Die Metallschicht 12 ist im Bereich der Biegekanten wie die gut wärmeleitende Schicht 5 der Leiterplatte 1 aus Fig. 1 bis 3 unterbrochen, um beim Umbiegen der Leiterplatte den Verbund unterschiedlicher Materialien nicht zu zerstören. Die im Bereich der Biegekanten in die elektrisch isolierende Schicht 2 der noch nicht umgebogenen Leiterplatte eingebrachte Vertiefung 7 ist auch hier eine Kerbe mit einem Querschnitt, der in etwa einen rechten Winkel darstellt. Die Leiterplatte ist im Gegensatz zu Fig. 1 bis 3 in Richtung der Seite der Leiterplatte umgebogen, von der die Kerbe 7 eingebracht ist. Im dargestellten unförmig gebogenen Zustand der Leiterplatte ist die Kerbe 7 geschlossen. Wird die Leiterplatte in dieser Richtung um einen bestimmten Biegewinkel umgebogen, muß die Kerbe 7 im nicht gebogenen Zustand der Leiterplatte im Querschnitt einen Winkel darstellen, der mindestens so groß wie der Biegewinkel ist. Um Schaltungselemente, die auf der im Bereich der Biegekanten unterbrochenen zweiten Metallschicht 12 angeordnet sind, über die Biegekanten hinweg auf einfache Weise elektrisch zu verbinden, sind metallisierte die elektrische isolierende Schicht 2 durchsetzende Kontaktbohrungen 13 vorgesehen. Diese dienen zur elektrischen Verbindung zweier auf verschiedenen Seiten der Biegekanten liegender und aus der zweiten Metallschicht 12 gebildeter Leiterbahnen. Die beiden Leiterbahnen 1 werden mit Hilfe der Kontaktbohrungen 13 mit einer aus der ersten nicht unterbrochenen Metallschicht 3 gebildeten dritten Leiterbahn kontaktiert, die die elektrische Verbindung über die Biegekante führt.

## Patentansprüche

1. Elektronisches Schaltungsmodul mit einer Leiterplatte (1) mit einer elektrisch isolierenden Schicht (2), an deren erster Seite eine erste Metallschicht (3) zur Bildung von Leiterbahnen und zum Tragen von oberflächenmontierbaren Bauelementen (4) angebracht ist, wobei die Leiterplatte (1) mindestens eine Biegekante aufweist, an der die elektrisch isolierende Schicht (2) eine im nicht gebogenen Zustand der Leiterplatte eingebrachte Vertiefung (7) aufweist und um die ein Abschnitt der Leiterplatte (1) umgebogen ist,
dadurch gekennzeichnet,
daß an der zweiten Seite der elektrisch isolierenden Schicht (1) eine zweite Metallschicht (12) zur Bildung von Leiterbahnen und zum Tragen von oberflächenmontierbaren Bauelementen (4) angebracht ist, und daß diese zweite Metallschicht (12) im Bereich der mindestens einen Biegehante unterbrochen ist.

2. Elektrisches Schaltungsmodul nach Anspruch 1,
dadurch gekennzeichnet, daß
die Vertiefung (7) als Kerbe ausgebildet ist, die im nicht gebogenen Zustand der Leiterplatte (1) einen Querschnitt aufweist, der in etwa einen rechten Winkel darstellt.

3. Elektrisches Schaltungsmodul nach Anspruch 1 oder 2, dadurch gekennzeichnet, daß
die Leiterplatte (1) u-förmig gebogen ist.

4. Elektronisches Schaltungsmodul nach einem der Ansprüche 1 bis 3,
dadurch gekennzeichnet,
daß in den Randbereich eines Abschnitts der Leiterplatte (1) elektrische Anschlußstifte (6) gefräst sind.

5. Elektronisches Schaltungsmodul nach einem der Ansprüche 1 bis 4,
dadurch gekennzeichnet,
daß ein quaderförmiger auf seiner Unterseite offener Metallaufsatz (8) für die Leiterplatte (1) vorgesehen ist.

6. Elektronisches Schaltungsmodul nach Anspruch 5,
dadurch gekennzeichnet,
daß der Metallaufsatz (8) an den Unterkanten seiner Seitenwände Lötstifte (9) aufweist.

7. Elektronisches Schaltungsmodul nach Anspruch 5 oder 6,
dadurch gekennzeichnet,
daß auf der Oberseite des Metallaufsatzes (8) ein Kühlkörper angeordnet ist.

## Claims

1. Electronic circuit module having a printed circuit board (1) with an electrically insulating layer (2) whose first side has a first metal layer (3) for forming conductor tracks and for supporting surface-mountable components (4) applied to it, the printed circuit board (1) having at least one bent edge at which the electrically insulating layer (2) has a depression (7) which is introduced when the printed circuit board is in the unbent state, and around which bent edge a portion of the printed circuit board (1) is bent, characterized in that a second metal layer (12) for forming conductor tracks and for supporting surface-mounted components (4) is applied to the second side of the electrically insulating layer (2), and in that this second metal layer (12) is interrupted in the region of the at least one bent edge.

2. Electronic circuit module according to Claim 1, characterized in that the depression (7) is designed as a notch which, when the printed circuit board (1) is in the unbent state, has a cross section which is approximately a right angle.

3. Electronic circuit module according to Claim 1 or 2, characterized in that the printed circuit board (1) is bent in the shape of a U.

4. Electronic circuit module according to one of Claims 1 to 3, characterized in that electrical connection pins (6) are milled in the edge region of a portion of the printed circuit board (1).

5. Electronic circuit module according to one of Claims 1 to 4, characterized in that a cuboid metal attachment (8) which is open on its underside is provided for the printed circuit board (1).

6. Electronic circuit module according to Claim 5, characterized in that the metal attachment (8) has solder pins (9) at the bottom edges of its side walls.

7. Electronic circuit module according to Claim 5 or 6, characterized in that a heat sink is arranged on the top of the metal attachment (8).

## Revendications

1. Module de circuit électronique, avec une plaque conductrice (1) avec une couche électriquement isolante (2), sur la première face de laquelle est appliquée une première couche métallique (3) pour constituer des pistes conductrices et pour supporter des composants (4) à montage en surface, la plaque conductrice (1) présentant au moins une arête de cintrage, où la couche électriquement isolante (2) présente un creux (7) réalisé dans l'état non cintré de la plaque conductrice et autour duquel une découpe de la plaque conductrice (1) est cintrée,
caractérisé en ce qu'
une seconde couche métallique (12) est appliquée sur la seconde face de la couche électriquement isolante (1) pour constituer des pistes conductrices et pour supporter des composants (4) à montage en surface, et en ce que cette seconde couche métallique (12) est interrompue dans la zone d'une arête cintrée au moins.

2. Module de circuit électrique selon la revendication 1,
caractérisé en ce que
le creux (7) est formé en entaille, qui dans l'état non cintré de la plaque conductrice (1), présente une coupe transversale qui représente environ un angle droit.

3. Module de circuit électrique selon la revendication 1 ou 2, caractérisé en ce que la plaque conductrice (1) est pliée en forme de U.

4. Module de circuit électronique selon l'une des revendications 1 à 3,
caractérisé en ce que
des broches de raccordement électrique (6) sont fraisées dans le périmètre d'une découpe de la plaque conductrice (1).

5. Module de circuit électronique selon l'une des revendications 1 à 4,
caractérisé en ce qu'
un couvercle métallique (8), ouvert sur sa face inférieure, de forme parallélépipédique, est prévu pour la plaque conductrice (1).

6. Module de circuit électronique selon la revendication 5,
caractérisé en ce que
le couvercle métallique (8) présente des bornes de soudure (9) aux arêtes inférieures de ses parois latérales.

7. Module de circuit électronique selon la revendication 5 ou 6,
caractérisé en ce qu'
un corps réfrigérant est disposé sur la face supérieure du couvercle métallique (8).
